# EUROPÄISCHE PATENTSCHRIFT

(11) **EP 2 630 650 B1**
(45) Veröffentlichungstag und Bekanntmachung des Hinweises auf die Patenterteilung: **05.10.2016**
(21) Anmeldenummer: 11813313.1
(22) Anmeldetag: 17.09.2011
(51) Int. Cl.: H01J 37/34, C23C 14/35

(54) **SPUTTERQUELLEN FÜR HOCHDRUCKSPUTTERN MIT GROSSEN TARGETS UND SPUTTERVERFAHREN**
SPUTTERING SOURCES FOR HIGH-PRESSURE SPUTTERING WITH LARGE TARGETS AND SPUTTERING METHOD
SOURCES DE PULVÉRISATION CATHODIQUE POUR LA PULVÉRISATION CATHODIQUE SOUS HAUTE PRESSION SUR DE GRANDES CIBLES ET PROCÉDÉ DE PULVÉRISATION CATHODIQUE

(30) Priorität: 22.10.2010 DE 102010049329
(43) Veröffentlichungstag der Anmeldung: 28.08.2013
(73) Patentinhaber: Forschungszentrum Jülich GmbH, 52425 Jülich (DE)
(72) Erfinder: FALEY, Mikhail, 52428 Jülich (DE); POPPE, Ulrich, 52349 Düren (DE)
(86) Internationale Anmeldenummer: PCT/DE2011/001744
(87) Internationale Veröffentlichungsnummer: WO 2012/051980

(56) Entgegenhaltungen:
- EP-A2- 0 295 649
- WO-A1-2006/034598
- WO-A1-2009/078094
- WO-A1-2009/157186
- US-A1- 2002 008 017
- US-A1- 2004 140 204
- US-A1- 2008 242 087
- US-B1- 6 432 285

## Beschreibung

### Stand der Technik

Beim Sputtern wird in einer Sputterkammer zunächst ein Vakuum hergestellt und dann eine Atmosphäre eines Sputtergases mit einem definierten Druck hergestellt. In der Nähe eines auf einem Sputterkopf angebrachten Sputtertargets, das in der Regel auf negativem Potential gehalten wird, wird eine Gasentladung des Sputtergases gezündet. Aus den elektrisch neutralen Atomen bzw. Molekülen des Sputtergases entsteht dabei ein Sputterplasma aus positiv geladenen Ionen und freien Elektronen. Die positiv geladenen Ionen werden durch das negative Potential des Targets auf dessen Oberfläche beschleunigt und schlagen dort durch Impulsübertrag Material heraus, das durch den Rückstoß zum Teil in Richtung des zu beschichtenden Substrats fliegt und dort deponiert wird. Gleichzeitig setzen sie durch diesen Beschuss Elektronen aus dem Target frei, die durch das elektrische Feld in Richtung des Sputterplasmas beschleunigt werden und dort weitere Atome bzw. Moleküle des Sputtergases durch Stöße ionisieren. Auf diese Weise erhält sich das Sputterplasma selbst.

Um größere Substrate in einem Arbeitsgang beschichten zu können, wird angestrebt, größere Sputtertargets zu verwenden. Mit zunehmender Targetgröße wird das Plasma allerdings zunehmend instabil. Dem wird beim Magnetronsputtern entgegen gewirkt, indem das Plasma von den Feldlinien eines permanentmagnetischen Feldes durchzogen wird. Dieses Feld verläuft bei runden Sputtertargets in der Regel zwischen einem am Rand der Aufnahme für das Sputtertarget angebrachten permanentmagnetischen Ring und einem im Zentrum dieser Target-Aufnahme angebrachten weiteren Permanentmagneten. Dabei verläuft ein Teil des magnetischen Streufeldes in gekrümmten Feldlinien durch den Raum, in dem sich das Sputterplasma befindet. Dieses magnetische Streufeld zwingt freie Elektronen auf lange Zykloidenbahnen quer zu den elektrischen und magnetischen Feldern durch das Sputterplasma, wo sie durch eine Vielzahl von Stößen Atome des Sputtergases ionisieren und so zum Erhalt des Plasmas beitragen.

Nachteilig funktioniert dieses Verfahren nur bei vergleichsweise geringem Druck. Bei höherem Druck wird die mittlere freie Weglänge für die Elektronen zu gering, so dass sie sich nur dort sammeln, wo das magnetische Feld am stärksten ist. Wo dieses Feld schwächer ist, wird auch das Plasma schwächer. Im Ergebnis wird die Stärke des Sputterplasmas über die Oberfläche des Sputtertargets inhomogen. Im Extremfall zerfällt das Plasma in mehrere voneinander getrennte Teile, welche meistens neben den magnetischen Polen des Permanentmagneten lokalisiert sind.

Ein höherer Druck wird aber speziell für das Sputtern oxidischer Schichten in Sauerstoffatmosphäre benötigt. Zum Einen führt die verkürzte mittlere freie Weglänge dazu, dass weniger negative Sauerstoffionen unerwünschterweise durch Abstoßung vom Target auf das Substrat geschleudert werden und dort die bereits deponierte Schicht schädigen oder nicht-stöchiometrisch abtragen (Rücksputtereffekt). Zum Anderen ist ein hoher Druck vorteilhaft, um eine oxidische Schicht bei der Deposition mit der richtigen Stöchiometrie vom Target auf das Substrat zu übertragen. Einige Materialien können nur bei relativ hohem Sauerstoffpartialdruck überhaupt eine stabile stöchiometrische Phase in der deponierten Schicht ausbilden.

Aus der US 6432285 B1 ist ein Sputterkopf mit einer Aufnahme für ein Sputtertarget und einer oder mehreren Magnetteldquellen zur Erzeugung eines magnetischen Streufelds mit Feldlinien bekannt, die aus der der Oberfläche des Sputtertargets austreten und wieder in diese eintreten, wobei der Nordpol und der Südpol mindestens einer Magnetfeldquelle, zwischen denen sich das Streufeld ausbildet, 10 mm oder weniger voneinander entfernt sind.

Aus der WO 2009/157186 A1 ist ein Verfahren zur Sputterdeposition eines Targetmaterials auf einem Substrat bei einem Druck von 0,5 mbar oder mehr bekannt, bei dem zwischen der Targetoberfläche und dem Substrat ein Plasma des Sputtergases gebildet wird, wobei von der Targetoberfläche in Richtung des Plasmas emittierte Elektronen in Plasma durch die Feldlinien einer oder mehrerer Magnetfeldquellen abgelenkt werden, deren Nordpol und Südpol 10 mm voneinander entfernt sind, wobei die Stärke der Magnetfeldquellen von der Mitte zum Rand der Targetoberfläche hin zunimmt.

Die WO 2009/ 078094 A1 offenbart einen Sputterkopf mit einer Aufnahme für ein Sputtertarget und einer oder mehreren Magnetfeldquellen zur Erzeugung eines magnetischen Streufelds mit Feldlinien, die aus der Oberfläche des Sputtertargets austreten und wieder in diese eintreten, wobei der Nordpol und der Südpol mindestens einer Magnetfeldquelle, zwischen denen sich das Streufeld ausbildet, 10 mm oder weniger, voneinander entfernt sind.

### Aufgabe und Lösung

Es ist daher die Aufgabe der Erfindung, einen Sputterkopf zur Verfügung zu stellen, der bei hohem Druck ein über die gesamte Oberfläche des Sputtertargets stabiles Plasma erzeugt. Es ist weiterhin Aufgabe der Erfindung, ein Verfahren zur Verfügung zu stellen, mit dem Targetmaterial bei hohem Druck mit homogener Schichtdicke auf einem Substrat deponiert werden kann.

Diese Aufgaben werden erfindungsgemäß gelöst durch einen Sputterkopf gemäß Haupt- und Nebenanspruch sowie durch ein Verfahren gemäß weiterem Nebenanspruch. Weitere vorteilhafte Ausgestaltungen ergeben sich jeweils aus den darauf rückbezogenen Unteransprüchen.

### Gegenstand der Erfindung

Im Rahmen der Erfindung wurde ein Sputterkopf mit einer Aufnahme-Fläche für ein Sputtertarget (Target-Aufnahme-Fläche) auf einem Target-Halter (Grundkörper) entwickelt. Die Target-Aufnahme-Fläche kann auch beliebige Krümmung haben, wobei aus praktischer Sicht die Form einer Ebene mehrere Vorteile hat. Zum Sputtern kann das Target auf der Target-Aufnahme-Fläche beispielsweise festgelötet, festgeklebt oder festgesintert werden. Der Sputterkopf weist eine oder mehrere Magnetfeldquellen zur Erzeugung eines magnetischen Streufelds mit Feldlinien auf, die aus der Oberfläche des Sputtertargets austreten und wieder in diese eintreten.

Erfindungsgemäß sind der magnetische Nordpol und der Südpol mindestens einer Magnetfeldquelle, zwischen denen sich das magnetische Streufeld ausbildet, 10 mm oder weniger, bevorzugt 5 mm oder weniger und ganz besonders bevorzugt etwa 1 mm, voneinander entfernt. Die untere sinnvolle Grenze für diesen Abstand ist durch den Abstand zwischen dem Sputtertarget und dem Sputterplasma (kathodischer Dunkelraum) bestimmt. Das Magnetfeld soll den Weg von Elektronen durch das Sputterplasma verlängern, um die Wahrscheinlichkeit, dass weitere Atome des Sputtergases entlang dieses Weges ionisiert werden, zu erhöhen. Hierzu muss es durch den kathodischen Dunkelraum hindurch bis in das Sputterplasma hineinreichen. Der erfindungsgemäße Sputterkopf ist dazu gedacht, das Sputtern bei hohem Druck von 0,5 mbar oder mehr, bevorzugt von 1 mbar oder mehr, zu verbessern. Bei einem solchen Druck erstreckt sich der kathodische Dunkelraum typischerweise über einige Zehntelmillimeter. Um einen Einfluss auf das Plasma zu haben, muss das Magnetfeld sowohl diesen Dunkelraum als auch die Entfernung von der Targetoberfläche bis zum Permanentmagneten überwinden.

Dann erscheint typischerweise 0,8 mm, bevorzugt etwa 1 mm, als der kleinste technisch sinnvolle Abstand zwischen dem magnetischen Nordpol und dem Südpol. Dabei ist mit dem Abstand zwischen dem Nordpol und dem Südpol, die beide in aller Regel in gewissem Umfang räumlich ausgedehnt sind, jeweils der kürzeste Abstand gemeint. Der kleine Abstand zwischen dem Südpol und dem Nordpol lokalisiert das Magnetfeld und maximiert die Komponenten des Streufeldes entlang der Target-Aufnahme-Fläche, also die Projektion des Streufeldes auf die Target-Aufnahme-Fläche.

Es wurde erkannt, dass gerade beim Sputtern unter hohem Druck zwischen etwa 0,5 und etwa 5 mbar durch ein solchermaßen lokal wirksames Magnetfeld der Ionisationsgrad des Sputterplasmas und damit auch die Abtragrate auf dem Sputtertarget lokal angepasst werden können. Hierzu machen sich die Erfinder zu Nutze, dass der Abstand zwischen dem Sputtertarget und dem Sputterplasma (kathodischer Dunkelraum) durch die mittlere freie Weglänge für Elektronen sowie Ionen des Sputtergases bestimmt wird, die wiederum stark druckabhängig ist. Bei geringerem Druck um die 10⁻² mbar oder weniger kann der kathodische Dunkelraum eine Ausdehnung von mehreren Zentimetern haben. Die langen Zykloidenbahnen der Elektronen im magnetischen Streufeld bewirken, dass schon in geringerer Entfernung vom Target Stöße zwischen den Elektronen und den Atomen des Sputtergases wahrscheinlicher werden. Dadurch wird das Plasma früher ionisiert; insofern reduziert sich der kathodische Dunkelraum etwas. Bei einem Sputtergas-Druck von 10⁻² mbar oder weniger lässt sich der kathodische Dunkelraum jedoch auch mit sehr starken Magnetfeldern die Ausdehnung des kathodischen Dunkelraums kaum unter 1 cm drücken. Ein in der beanspruchten Weise lokalisiertes Magnetfeld ist auch in der Raumdimension senkrecht zur Fläche der Target-Aufnahme so stark lokalisiert, dass nur ein Bruchteil der Feldlinien durch den kathodischen Dunkelraum bis in das Sputterplasma vordringt und dort die Magnetfeldstärke sehr schwach ist. Von der Oberfläche des Sputtertargets emittierte Elektronen können somit nicht entlang dieser Feldlinien durch das Sputterplasma geführt werden, so dass sie nur wenig zur weiteren Ionisation dieses Plasmas beitragen.

Bei einem Druck zwischen etwa 0,5 und etwa 5 mbar dagegen ist nur mehr ein kathodischer Dunkelraum der Größenordnung weniger als 1 mm oder sogar weniger als 0,1 mm vorhanden, der von dem lokalisierten Feld problemlos durchdrungen werden kann. Von der Targetoberfläche emittierte Elektronen werden hauptsächlich in einer Präzessionsbewegung quer zu den Feldlinien des magnetischen Feldes durch das Plasma geführt (Zykloidenbahnen), wodurch ihr Weg innerhalb des Plasmas verlängert wird. Es kommt zu einer erhöhten Anzahl an Stößen zwischen den Elektronen und den Atomen bzw. Molekülen des Sputtergases, wodurch dieses stärker ionisiert wird. Die positiv geladenen Ionen werden vom negativ geladenen Sputterkopf angezogen und tragen zum Materialabtrag bei. Auch beim Radio-Frequenz-Sputtern (RF-Sputtern) wird der Ionisationsgrad in ähnlicher Weise durch das lokale magnetische Streufeld lokal erhöht. Beim RF-Sputtern liegt zwischen der Target-Aufnahme und Masse an Stelle eines negativen Potentials ein hochfrequentes Wechselfeld an. Während der positiven Halbwelle des Wechselfeldes wird das Target jeweils polarisiert, und während der negativen Halbwelle wird Material abgetragen. Auf diese Weise können auch Isolatoren als Beschichtungsmaterialien verwendet werden.

Durch das lokal wirksame Magnetfeld kann somit der Ionisationsgrad des Plasmas und damit auch die Abtragrate beim Sputtern lokal angepasst werden. Als Folge hiervon lassen sich mit dem erfindungsgemäßen Sputterkopf bei ansonsten gleichen Parametern Schichten mit homogenerer Schichtdicke auf dem Substrat herstellen als mit Sputterköpfen nach dem Stand der Technik. Da der Ionisationsgrad des Sputterplasmas homogener verteilt ist als an Sputterköpfen nach dem Stand der Technik, können größere Sputterplasmen und damit auch größere Sputtertargets eingesetzt werden, so dass größere Werkstücke in einem Arbeitsgang beschichtet werden können. Als Nebeneffekt wird zudem das Target homogener abgenutzt. Beim konventionellen Magnetronsputtern ist der Abtrag beispielweise in einer kreisförmigen Rille konzentriert; ist das Target an dieser Stelle vollständig durchdrungen, muss es ausgewechselt werden, obwohl erst ein Bruchteil seiner Gesamtmasse abgetragen ist.

Diese Effekte kommen in besonderem Maße zum Tragen, wenn ein Sputtertarget und/oder ein Substrat zum Einsatz kommen, das wesentlich größer ist als der Abstand zwischen dem Sputtertarget und dem Substrat. Bei Sputtergas-Drücken ab etwa 0,5 mbar beträgt dieser Abstand nur etwa 10-30 mm

Es wurde weiterhin erkannt, dass beim Magnetronsputtern nach dem Stand der Technik die inhomogene Abtragrate der Einstieg in einen selbstverstärkenden Prozess ist, der das Sputterplasma bei Verwendung größerer Targets destabilisiert. Im Sputterplasma entsteht ständig Wärme, die auch das Target heizt. Dies gilt im Besonderen, wenn unter hohem Druck gesputtert wird und der kathodische Dunkelraum zwischen dem Plasma und dem Target sehr dünn ist. Indem Ionen des Sputtergases durch das negative Potential des Targets angezogen werden, fließt nun beim Sputtern ein positiver Strom in Richtung des Targets. Beim Sputtern in einer Sauerstoffatmosphäre werden zusätzlich negative Sauerstoffionen vom Target abgestoßen, was einer weiteren positiven Stromkomponente in Richtung des Targets entspricht. Das Target setzt dem Gesamtstrom einen Widerstand entgegen, der insbesondere bei halbleitenden Targets mit steigender Temperatur abnimmt. Wo das Target bereits heißer ist, konzentriert sich somit ein höherer Anteil des Sputterstroms. Dafür wird Strom von anderen Orten auf dem Target abgezogen. Bei kleineren Targets wirken Ausgleichsströme innerhalb des Targets diesem Prozess noch entgegen. Dies reicht bei größeren Targets jedoch nicht mehr aus, so dass an den Orten auf dem Target, an denen ein Mangel an Sputterstrom herrscht, das Sputterplasma zusammenbricht. Indem nun erfindungsgemäß von vornherein für eine homogene Ionisation des Plasmas und damit für eine homogene Abtragrate gesorgt wird, entsteht auf dem Target keine Ungleichverteilung des Sputterstroms, die sich in dieser Weise selbst verstärken könnte. Daher können mit dem erfindungsgemäßen Sputterkopf größere Targets gesputtert werden als beim herkömmlichen Magnetronsputtern.

Mit dem erfindungsgemäßen Sputterkopf lässt sich der Materialabtrag vom Sputtertarget auch in dem Sinne maßschneidern, dass Gebiete auf dem Target vom Abtrag verschont bleiben. Vorteilhaft liegt in der Projektion des Streufelds jeder Magnetfeldquelle auf die Oberfläche der Target-Aufnahme der Bereich, in dem mindestens 90 % der Feldstärke konzentriert sind, vollständig außerhalb eines vorgegebenen Bereichs, der vom Materialabtrag verschont bleiben soll. Als ein solcher Bereich kann beispielsweise der Randbereich (beispielsweise 20 % oder weniger, bevorzugt 10 % oder weniger und besonders bevorzugt 5 % oder weniger) eines runden Sputtertargets vorgegeben sein, wenn die Target-Aufnahme-Fläche für das Sputtertarget von einer Abschirmung zur räumlichen Beschränkung des Materialabtrags auf das Sputtertarget umgeben ist. Dann ist es unerwünscht, dass das Sputterplasma zu nahe an den Spalt zwischen der Target-Aufnahme und der Abschirmung herankommt, weil dies zu Überschlägen führen kann.

Die allgemeine Idee der Erfindung ist, Inhomogenitäten in der Stärke des Sputterplasmas durch lokale Beeinflussung des Sputterplasmas mit lokalen Magnetfeldern zu kompensieren. Dabei kommt es darauf an, dass im Gegensatz zum Magnetronsputtern nach dem Stand der Technik der von einer Magnetfeldquelle beeinflusste Bereich der Targetoberfläche klein gegen den gesamten Flächeninhalt der Targetoberfläche ist. Daher bezieht sich die Erfindung auch auf einen Sputterkopf mit einer Aufnahme für ein Sputtertarget und einer oder mehreren Magnetfeldquellen zur Erzeugung eines magnetischen Streufelds mit Feldlinien, die aus der Oberfläche des Sputtertargets austreten und wieder in diese eintreten, wobei dieser Sputterkopf dadurch gekennzeichnet ist, dass in der Projektion des Magnetfelds mindestens einer Magnetfeldquelle auf die Target-Aufnahme-Fläche mindestens 90 %, bevorzugt mindestens 95 %, der Feldstärke auf einem Flächenanteil von 10 % oder weniger, bevorzugt 5 % oder weniger und ganz besonders bevorzugt 1 % oder weniger an der Target-Aufnahme-Fläche konzentriert sind.

Die lokale Beeinflussung des Sputterplasmas mit lokalen Magnetfeldern verbessert die Homogenität der Beschichtung umso mehr, je größer das Sputtertarget ist. Vorteilhaft ist daher die Target-Aufnahme-Fläche zur Aufnahme eines Sputtertargets mit einem Durchmesser von 30 mm oder mehr, bevorzugt von 50 mm oder mehr und ganz besonders bevorzugt von 60 mm oder mehr, ausgebildet.

Die lokale Beeinflussung des Sputterplasmas mit lokalen Magnetfeldern hat aber auch die Wirkung, dass das verwendete Sputtertarget nicht kreisrund sein muss. Über die Positionen und Stärken der Magnetfeldquellen kann auf beliebig geformten Targetoberflächen eine Feldverteilung erzeugt werden, die zu einem Sputterplasma mit homogener Stärke und damit auch zu einem homogenen Materialabtrag führt. Somit bezieht sich die Erfindung ganz allgemein auch auf einen Sputterkopf mit einer Aufnahme für ein Sputtertarget und einer oder mehreren Magnetfeldquellen zur Erzeugung eines magnetischen Streufelds mit Feldlinien, die aus der Oberfläche des Sputtertargets austreten und wieder in diese eintreten, wobei dieser Sputterkopf dadurch gekennzeichnet ist, dass er zur Aufnahme eines nicht kreisrunden Targets, insbesondere eines Targets mit einer elliptischen, sternförmigen oder polygonalen Oberfläche, ausgebildet ist. Diese Ausbildung kann beispielsweise darin bestehen, dass die Target-Aufnahme-Fläche eine entsprechende Formgebung aufweist. Alternativ oder auch in Kombination hierzu kann eine Target-Aufnahme-Fläche, die größer und/oder anders geformt ist als die Oberfläche des Sputtertargets, aber auch durch einen vor der dem Sputterplasma zugewandten Oberfläche der Target-Aufnahme fixierbaren Festkörperisolator so abgeschattet sein, dass der Materialabtrag auf die Targetoberfläche oder Teile davon beschränkt ist. Es erfolgt dann kein Materialabtrag vom Sputterkopf selbst. Im speziellen Beschreibungsteil sind zwei Ausführungsbeispiele angegeben, die zur Beschichtung bandförmiger Substrate rechteckige Sputtertargets verwenden. Die Abtragrate wird in diesen Ausführungsbeispielen durch linienförmige Anordnungen von Magnetfeldquellen lokal an die Bandform des Substrats angepasst.

In einer besonders vorteilhaften Ausgestaltung der Erfindung weist der Sputterkopf einen Grundkörper, der die Targct-Aufnahme-Fläche und damit im Betrieb auch das Sputtertarget trägt, sowie zusätzlich eine das Sputtertarget umgebende Abschirmung zur räumlichen Beschränkung des Materialabtrags auf das Sputtertarget auf. Erfindungsgemäß ist zwischen dem Grundkörper (mit Target-Aufnahme-Fläche und Sputtertarget) und der Abschirmung ein Festkörperisolator angeordnet. Die Grundkörper mit Target-Aufnahme-Fläche und Sputtertarget befinden sich in der Regel auf einem elektrischen Potential, während die Abschirmung auf Massepotential liegt. Zwischen dem Grundkörper (mit Target-Aufnahme-Fläche und Sputtertarget) und der Abschirmung liegen daher Spannungen (beziehungsweise Wechselspannungsamplitude beim RF-Sputtern) von einigen hundert Volt an. Der Spalt zwischen Grundkörper (mit Target-Aufnahme-Fläche und Sputtertarget) und Abschirmung muss nun aber kleiner sein als die mittlere freie Weglänge, damit sich in ihm kein unerwünschtes Plasma ausbilden kann. In einem größeren Spalt können Elektronen durch Abstoßung vom negativen Potential beschleunigt werden und Gasatome ionisieren, wobei weitere Ionen und Elektronen freigesetzt werden. Dadurch kann sich lawinenartig ein Plasma im Spalt zwischen Abschirmung und Grundkörper mit Target-Aufnahme-Fläche und Sputtertarget ausbilden und zu elektrischen Überschlägen führen.

Mit zunehmendem Sputtergas-Druck sinkt nun die mittlere freie Weglänge und damit auch die zulässige Spaltbreite. Bei gleicher angelegter Spannung steigt also die elektrische Feldstärke über dem Spalt. Zugleich sinkt die Durchbruchsfeldstärke der Atmosphäre in der Sputterkammer, insbesondere wenn wie in den Versuchen der Erfinder eine sauerstoffhaltige Atmosphäre gewählt wird. Das Austreten von elektrischen Überschlägen kann daher der begrenzende Faktor für den maximalen praktikablen Sputtergas-Druck sein, bei dem gesputtert werden kann. Der Festkörperisolator hat nun eine deutlich höhere Durchbruchsfeldstärke als eine sauerstoffhaltige Atmosphäre. Zugleich nimmt er ein Volumen zwischen Grundkörper (mit Target-Aufnahme-Fläche und Sputtertarget) und Abschirmung ein, das nicht mehr als Beschleunigungsstrecke für Elektronen zur Verfügung steht. Im Ergebnis bewirkt der Festkörperisolator somit, dass bis zu einem deutlich höheren Druck gesputtert werden kann. Je vollständiger der Festkörperisolator den Zwischenraum zwischen Grundkörper und Abschirmung ausfüllt, desto besser wird die Bildung eines unerwünschten Plasmas in diesem Zwischenraum unterdrückt.

Eine obere Grenze für den Sputtergas-Druck entsteht durch die mit steigendem Druck überproportional fallende mittlere freie Weglänge. Jenseits von etwa 5 mbar bildet sich das Sputterplasma nur noch in geringer Entfernung (etwa 1 mm oder weniger) vorn Sputtertarget aus, weil in weiter entfernten Bereiche des Sputtergases die Elektronen nicht mehr hinreichend Energie haben, um die Atome des Sputtergases zu ionisieren. Ist erst einmal ein Plasma in der Nähe des Targets entstanden, finden jenseits dieses Plasmas keine weiteren Ionisationen statt, weil das Potential des Sputtertargets gegen Masse im Wesentlichen bereits über dem kathodischen Dunkelraum bis zum Plasma abfällt. Jenseits des Plasmas werden die Elektronen nicht mehr beschleunigt. Dementsprechend konzentriert sich auch die im Plasma erzeugte Wärme auf ein kleineres Gebiet. Die Targetoberfläche erhitzt sich stark inhomogen, und das Sputterplasma wird instabil. Erfindungsgemäß sind die magnetischen Pole mindestens einer Magnetfeldquelle minimal nur etwa 1 mm, voneinander entfernt, was bei Sputtergas-Drücken oberhalb von etwa 5 mbar die Stabilisierung des etwa 1 mm dünnen Sputterplasmas sehr erschwert.

Vorteilhaft umfasst die Magnetfeldquelle mindestens einen Permanentmagneten, dessen Feld durch ein Joch aus magnetisch permeablem Material zur Target-Aufnahme-Fläche geführt ist. Besteht ein solches Joch beispielsweise aus einem Metall, wie etwa Eisen, kann es deutlich einfacher mechanisch zur gewünschten Geometrie bearbeitet werden als typische Materialien, aus denen kleine Permanentmagnete mit hoher Feldstärke gefertigt werden. Dies gilt insbesondere in einer weiteren vorteilhaften Ausgestaltung der Erfindung, in der die Flüsse mehrerer Permanentmagnete durch ein und dasselbe Joch geführt sind. In dieser Ausgestaltung weist das Joch eine komplizierte mechanische Geometrie auf. Ein Ausführungsbeispiel der Erfinder sieht ein Eisenjoch und einen Kupfer-Halter vor, in den Bohrungen zur Aufnahme kleiner Permanentmagnete eingebracht sind. Das Eisen und das Kupfer lassen sich jeweils problemlos mechanisch bearbeiten. Die Permanentmagnete bestehen dagegen aus gesintertem Pulver einer Seltenerd-Legierung und sind sehr spröde, so dass sie beim Versuch einer mechanischen Bearbeitung zerbrechen. Die Permanentmagnete können in Bohrungen im Kupfer-Halter sitzen. Sie induzieren ein magnetisches Feld in Richtung der Target-Aufnahme. Im Eisenjoch wird das magnetische Feld von der Target-Aufnahme-Fläche zurück zum rückwärtigen Pol des Permanentmagneten geführt. So wird das gesamte magnetische Streufeld nur in der Nähe der Target-Aufnahme-Fläche produziert.

Die Magnetfeldquelle kann aber auch mindestens einen Elektromagneten umfassen. Dies hat den Vorteil, dass seine Feldstärke in-situ ohne Bruch des Vakuums geändert werden kann, um die Abtragrate lokal anzupassen. Allerdings ist es technologisch anspruchsvoll, die benötigten Feldstärken auf sehr engem Raum zu erzeugen, da dies entweder viele Windungen oder einen hohen Strom erforderlich macht.

Vorteilhalt sind eine oder mehrere ring-, waben- oder linienförmige Anordnungen von Magnetfeldquellen vorgesehen. Dabei können die einzelnen Magnetfeldquellen unterschiedliche Feldstärken aufweisen. Mit derartigen Anordnungen lässt sich die Abtragrate über die Targetoberfläche homogen gestalten oder anderweitig maßschneidern. Da die Magnetfeldquellen crlindungsgemäß jeweils nur lokal wirksame Felder erzeugen, können ihre Feldstärken unabhängig voneinander auf eine gewünschte Verteilung der Abtragrate hin optimiert werden. Hierzu ist es besonders vorteilhaft, wenn die Abstände zwischen benachbarten Magnetfeldquellen so gewählt sind, dass die Bereiche, in denen jeweils 90 % des Feldes jeder Quelle konzentriert sind, sich nicht überlappen.

In den Versuchen der Erfinder variierte die auf einem kreisrunden Substrat mit einem Durchmesser von 30 mm aufgebrachte Schichtdicke über die Oberfläche des Substrats um bis zu 50 %, wenn ein kreisrundes Sputtertarget nach dem Stand der Technik verwendet wurde. Wurde das gleiche Target dagegen zusammen mit einem erfindungsgemäßen Sputterkopf mit nur einer ringförmigen Anordnung von Magnetfeldquellen eingesetzt, variierte die Schichtdicke nur noch um bis zu 10 %. Eine homogene Verteilung der Schichtdicke ist insbesondere für die Herstellung lateral strukturierter Mehrlagensysteme wesentlich. Solche Herstellungsprozesse beinhalten in der Regel flächendeckende Ätzschritte durch, zum Beispiel, einen Ionenbeschuss aus einer Ionenkanone, die sich nicht selbst limitieren, sondern nach dem Durchätzen der zu bearbeitenden Schicht im richtigen Moment aktiv gestoppt werden müssen. Variiert die Schichtdicke, wird die Schicht an einigen Stellen nicht vollständig weggeätzt, und/oder es wird an anderen Stellen die darunterliegende Schicht geschädigt.

Bei der Optimierung der Feldstärken benötigt der Fachmann eine Rückkopplung. Diese kann er sich beispielsweise verschaffen, indem er mit einer Anordnung von Magnetfeldquellen eine Schicht auf einem Substrat deponiert und die Verteilung der Schichtdicke über das Substrat untersucht. Weicht die Schichtdicke an einer Stelle vom gewünschten Ergebnis ab, ist dies ein Signal dafür, dass an einer bestimmten Stelle des Sputtertargets die Abtragrate zu erhöhen oder zu senken ist.

Das an einer bestimmten Stelle auf dem Substrat deponierte Material ist eine Überlagerung des von mehreren Stellen des Sputtertargets, an denen sich Magnete befinden, abgetragenen Materials. In erster Annäherung ist der Anteil der lokalen Depositionsrate an einem Aufpunkt auf dem Substrat, der durch das von einem bestimmten Ort "k" auf dem Target stammende Material bewirkt wird, proportional zum lokalen Ionisationsgrad beziehungsweise zur lokalen Magnetfeldstärke am Ort "k". Mit dieser Erkenntnis kann man die erforderliche optimale Magnetfeldstärkeverteilung für die gewünschte räumliche Verteilung der Depositionsrate auf dem Substrat simulieren und die Magnetfeldquellen entsprechend positionieren. Hierzu kann beispielsweise ein lineares Gleichungssystem aufgestellt werden, in dem die lokalen Magnetfeldstärken gesucht sind und die gewünschten lokalen Depositionsraten auf der rechten Seite stehen. Die stark lokalisierte Wirkung der Magnetfeldquellen hat dann zur Folge, dass es keine komplizierten nichtlinearen Kopplungsterme zwischen den einzelnen Gleichungen gibt.

Die Verteilung der Schichtdicke ist besonders beim Sputtern mit hohem Druck in dieser Weise optimierbar, weil sich das Substrat dann in vergleichsweise geringem Abstand (etwa 20 mm) zum Sputtertarget befindet und sich die aus dem Sputtertarget herausgeschlagenen Atome bzw. Moleküle im Wesentlichen in gerader Linie in Richtung des Substrats bewegen. Beim Sputtern mit geringerem Druck sind sowohl der kathodische Dunkelraum als auch das Plasma selbst deutlich größer, so dass die Atome bzw. Moleküle einen deutlich längeren Weg vom Sputtertarget zum Substrat zurücklegen. Es ist dann nur noch schwer nachvollziehbar, von welchen Orten auf dem Sputtertarget das Material stammt, das an einem gegebenen Ort auf dem Substrat deponiert wurde.

Der einer Abschirmung nächstgelegene Randbereich eines Sputtertargets kann nicht nur durch Maßschneidern des vorgelegten Magnetfelds vom Materialabtrag ausgenommen werden. Alternativ oder auch in Kombination zu den bisher beschriebenen Maßnahmen bezieht sich die Erfindung allgemein auch auf einen Sputterkopf mit einer Aufnahme für ein Sputtertarget mit einer die Target-Aufnahme umgebenden Abschirmung zur räumlichen Beschränkung des Materialabtrags auf das Sputtertarget, wobei ein vor der dem Sputterplasma zugewandten Oberfläche des Sputtertargets oder der Target-Aufnahme fixierbarer Festkörperisolator vorgesehen ist, welcher im Betrieb die am nächsten zur Abschirmung gelegenen 20 % oder weniger, bevorzugt die am nächsten zur Abschirmung gelegenen 10 % oder weniger und ganz besonders bevorzugt die am nächsten zur Abschirmung gelegenen 5 % oder weniger dieser Oberfläche vom Materialabtrag auszunehmen vermag.

Diese Maßnahme verhindert Überschläge, die durch eine zu große Annäherung des Sputterplasmas an den Spalt zwischen der Target-Aufnahme und der Abschirmung hervorgerufen werden. Indem dieser Bereich durch den Festkörperisolator maskiert wird, kann durch ein kleines Opfer an nutzbarer Targetoberfläche die Stabilität des Plasmas überproportional verbessert werden.

Es ist ein Leitmotiv der vorliegenden Erfindung, beim Sputtern unter hohem Sputtergas-Druck durch lokale Beeinflussung des Materialabtrags vom Sputtertarget die Qualität der erhaltenen Schichten und hier insbesondere die Homogenität der Schichtdicke zu verbessern. Diesem Leitmotiv liegt die Erkenntnis zugrunde, dass gerade beim Sputtcrn unter hohem Sputtergas-Druck wegen der dann vergleichsweise geringen Entfernung zwischen Sputtertarget und Substrat eine nachvollziehbare Kausalbeziehung zwischen dem Materialabtrag an einem gegebenen Ort auf dem Sputtertarget und der Materialdeposition an einem gegebenen Ort auf dem Substrat besteht. Die Beeinflussung kann mit einer geeigneten Anordnung von Magnetfeldquellen bewirkt werden. Sie kann vorteilhaft auch in Kombination hierzu mit dem vor dem Sputtertarget fixierbaren Festkörperisolator bewirkt werden.

Dieses Leitmotiv ist auch in dem erfindungsgemäßen Verfahren zur Sputterdeposition eines Targetmaterials auf einem Substrat bei einem Sputtergas-Druck von 0,5 mbar oder mehr, bevorzugt von 1 mbar oder mehr, verwirklicht. Bei dem Verfahren wird zwischen der Targetoberfläche und dem Substrat ein Plasma des Sputtergases gchildct. Erfingdungsgemäß werden von der Targetoberfläche in Richtung des Plasmas emittierte Elektronen im Plasma durch die Feldlinien einer oder mehrerer Magnetfeldquellen abgelenkt, deren magnetischer Nordpol und Südpol 10 mm oder weniger, bevorzugt 5 mm oder weniger und ganz besonders bevorzugt etwa 1 mm, voneinander entfernt sind.

Analog zur vorhergehenden Beschreibung der Sputterköpfe ist hierdurch gewährleistet, dass der Ionisationsgrad des Sputterplasmas und damit auch die Rate des Materialabtrags vom Target lokal angepasst werden können. Dies verbessert die Stabilität des Sputterplasmas und ermöglicht daher die Verwendung größerer Sputtertargets bei gleichzeitig verbesserter Homogenität der auf dem Substrat erhaltenen Schichtdicke, insbesondere dann, wenn in einer vorteilhaften Ausgestaltung des Verfahrens ein erfindungsgemäßer Sputterkopf verwendet wird.

### Spezieller Beschreibungsteil

Nachfolgend wird der Gegenstand der Erfindung anhand von Figuren näher erläutert, ohne dass der Gegenstand der Erfindung dadurch beschränkt wird. Es ist gezeigt:
- Figur 1:: Sputterquelle mit einem Ausführungsbeispiel des erfindungsgemäßen Sputterkopfes.
- Figur 2:: Für Sputtertargets mit über 50 mm Durchmesser geeignete Sputterquelle mit einem erfindungsgemäßen Sputterkopf, der mehrere konzentrische ringförmige Anordnungen von Magnetfeldquellen aufweist.
- Figur 3:: Für Sputtertargcts mit über 60 mm Durchmesser geeigneter Sputterkopf mit einer wabenförmigen Anordnung von Magnetfeldquellen.
- Figur 4:: Sputterquelle mit einem Ausführungsbeispiel des erfindungsgemäßen Sputterkopfes zur Beschichtung langer Substrate oder Bänder.
- Figur 5:: Abwandlung des in Figur 4 gezeigten Ausführungsbeispiels mit höherer Beschichtungsrate pro Zeiteinheit.
- Figur 6:: Homogenisierung der Schichtdickrnverteilung auf einem Substrat mit 30 mm Durchmesser durch Optimierung der Verteilung und Stärke lokaler Magnetfeldquellen.

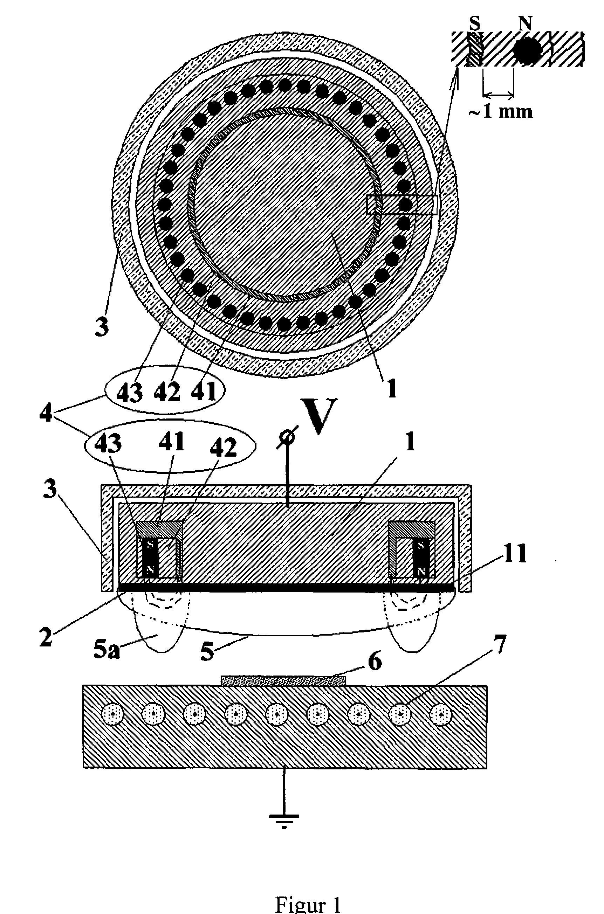

Figur 1 zeigt den schematischen Aufbau einer Sputterquelle mit einem Ausführungsbeispiel des erfindungsgemäßen Spulterkopfes. Der Sputterkopf ist einmal als Schnitt mit einer zur Substratoberfläche parallelen Ebene dargestellt und einmal als Schnitt mit einer hierzu um 90° aus der Zeichenebene heraus gedrehten Ebene. Er umfasst einen Grundköper 1 mit einer Target-Aufnahme-Fläche 11 für ein Sputtertarget 2 von 50 mm Durchmesser. Der Grundkörper 1, der auf ein Potential V gebracht werden kann, ist ein wassergekühlter Kupferblock. Der Grundkörper und damit auch die Target-Aufnähme-Fläche 11 sind von einer (in Figur 1 nicht eingezeichneten) Abschirmung auf Massepotential verbunden und werden durch den Festkörperisolator 3 von dieser Abschirmung beabstandet. In dem Grundkörper befindet sich eine ringförmige Anordnung 4 von Magnetfeldquellen. Diese Anordnung 4 umfasst einen umlaufenden Jochring 41 aus Eisen mit einer Aussparung, in die ein Trägerring 42 aus Kupfer eingesetzt ist. Der Trägerring 42 weist Bohrungen auf, in die Permanentmagnete 43 eingesetzt sind. Der Grundkörper 1 enthält einen Einbauraum für den mit Trägerring 42 und Permanentmagneten 43 (etwa aus SmCo₅ oder Sm₂Co₁₇) bestückten Jochring 41, so dass die Permanentmagnete 43 in unmittelbare Nähe des Targets 2 gebracht werden können.

Die Permanentmagnete 43 können unmittelbar an die Target-Aufnahme-Fläche 11 angrenzen, so dass das lokale magnetische Streufeld jeweils voll genutzt wird. Die verwendbare Sputterleistung ist dann durch die am Sputtertarget 2 produzierte Wärmemenge begrenzt. Daher befindet sich in diesem Ausführungsbeispiel zwischen den Magneten und der Target-Aufnahme-Fläche vorteilhaft noch eine Lage des Materials des Grundkörpers. Diese Lage führt die am Sputtertarget 2 produzierte Wärme zumindest zum Teil ab. so dass das Sputtertarget auch bei größeren Leistungen homogen gekühlt bleibt und der vom Sputtertarget ausgehende Wärmestrom zumindest zum Teil von den Permanentmagneten 43 ferngehalten wird. Auf diese Weise ist gewährleistet, dass auch bei größeren Leistungen die Permanentmagnete 43 deutlich unterhalb ihrer Curie-Temperatur bleiben und ihren Ferromagnetismus behalten. Zugleich wird auch bei größeren Leistungen vermieden, dass sich der Wärmestrom an den Permanentmagneten staut, weil das zwischen den Permanentmagneten 43 und der Target-Aufnahme-Fläche 11 befindliche metallische Kupfer ein deutlich besserer Wärmeleiter ist als die Permanentmagnete 43, die gesinterte keramische Körper sind.

Jeder der Permanentmagnete 43 hat einen magnetischen Nordpol und einen magnetischen Südpol. Der Nordpol befindet sich in diesem Ausführungsbeispiel in der Nähe zur Target-Aufnahme-Fläche 11, der Südpol ist durch den Jochring 41 um den Magneten 43 und den Trägerring 42 herum in die Nähe der Target-Aufnahme-Fläche 11. geführt. Dies ist in Figur 1 durch eine Detailvergrößerung verdeutlicht. Somit befinden sich in unmittelbarer Nähe der Target-Aufnahme-Fläche 11 und damit des Targets 2 ein magnetischer Nord- und Südpol. Zwischen beiden Polen bildet sich ein magnetisches Streufeld aus, das jenseits des Targets in das Sputterplasma hineinreicht und dort Elektronen auf Zykloidenbahnen innerhalb des Plasmas hält.

Ohne die Anordnung 4 ergibt sich vor dem Target 2 eine Verteilung des Sputterplasmas der Gestalt 5. Das Plasma ist am Rand des Targets 2 wesentlich schwächer als in dessen Mitte. Dadurch wird auf dem Substrat 6, das auf einem geerdeten Substratheizer 7 bereitgestellt ist, eine Schicht deponiert, deren Dicke stark inhomogen verteilt ist. Am Rand des Substrats ist die Schicht nur noch halb so dick wie in der Mitte. Erfindungsgemäß wird durch jeden der Permanentmagnete 43 das Sputterplasma lokal verstärkt, was durch zusätzliche Beiträge 5a zur Verteilung des Sputterplasmas angedeutet ist. Insgesamt sind der Ionisationsgrad des Sputterplasmas und damit auch die Abtragrate deutlich homogener verteilt. Dementsprechend fällt auch die Dicke der auf dem Substrat 6 deponierten Schicht zum Rand hin nur noch um 10 % gegenüber ihrem Wert in der Mitte des Substrats 6 ab.

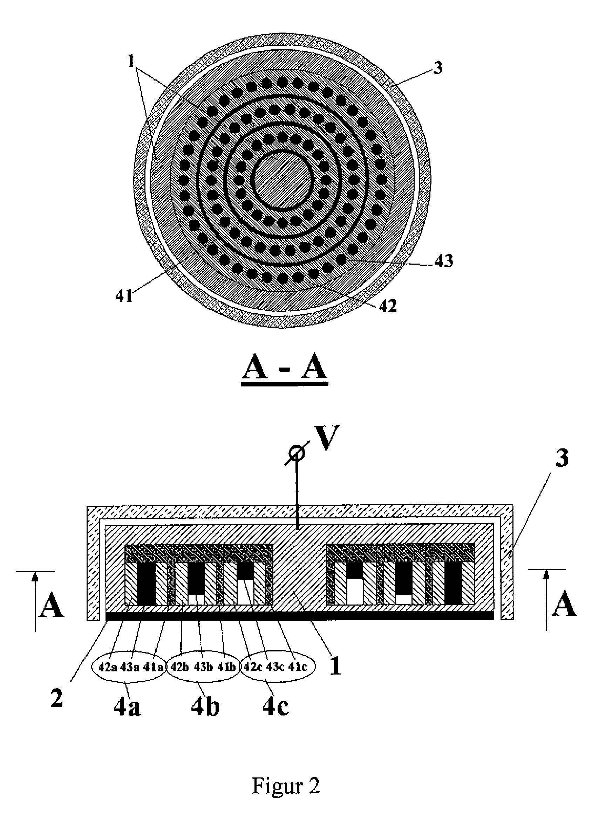

Figur 2 zeigt ein weiteres Ausführungsbeispiel des erfindungsgemäßen Sputterkopfes mit drei konzentrisch zueinander angeordneten, ringförmigen Anordnungen 4a, 4b und 4c von Magnetfeldquellen für ein im Vergleich zu Figur 1 etwas größeres Target. Jede dieser Anordnungen ist nach dem gleichen Schema aufgebaut wie die Anordnung 4 in Figur 1. Die Anordnung 4a umfasst Jochring 41a, Trägerring 42a und Permanentmagnete 43 a. Die Anordnung 4b umfasst Jochring 41 b, Trägerring 42b und Permanentmagnete 43b. Die Anordnung 4c umfasst Jochring 41c, Trägerring 42c und Permanentmagnete 43c. Dabei müssen die Jochringe 41a, 41b und 41c keine separaten Komponenten sein; stattdessen kann ein gleichwertiges Joch 41 aus einem Stück gefertigt werden. Der Sputterkopf ist, wie auch in Figur 1, einmal als Schnitt mit einer zur Substratoberfläche parallelen Ebene dargestellt und einmal als Schnitt mit einer hierzu um 90° aus der Zeichenebene heraus gedrehten Ebene. Die Orientierung beider Schnitte zueinander ist in Figur 2 durch die Schnittlinic A-A angegeben.

Die Permanentmagneten 43a der Anordnung 4a erzeugen lokal die stärksten Magnetfelder. Demgegenüber erzeugen die Permanentmagnete 43b und 43c der Anordnungen 4b und 4c jeweils schwächere Magnetfelder. Wie im unteren Teil von Figur 2 sichtbar, ist dies realisiert, indem die Permanentmagnete 43b und 43c gegenüber den Permanentmagneten 43a jeweils verkürzt sind, wobei ihr oberes Ende (magnetischer Südpol) jeweils an den Jochring 41a, 41b bzw. 41c angrenzt.

Dabei ziehen sich die Permanentmagnete 43a, 43b und 43c einerseits und der Jochring 41a, 41b bzw. 41c andererseits jeweils gegenseitig an, so dass die Permanentmagnete mechanisch fixiert sind und keine Klebung erforderlich ist. Die Permanentmagnete könnten alternativ jeweils mit ihrem unteren Ende (magnetischer Nordpol) an die Lage des Grundkörpermaterials angrenzen, die sie von der Target-Aufnahme-Fläche 11 trennt. Dann würde ein größerer Anteil des von den Permanentmagneten 43b und 43c erzeugten Streufeldes das Sputterplasma erreichen. Dies ist allerdings mechanisch etwas komplizierter zu fertigen, weil die Jochringe 41a, 41b und 41c jeweils Zapfen aufweisen müssten, die genau bis zu den magnetischen Südpolen der Permanentmagnete 43a, 43b bzw. 43c reichen.

Der Unterschied in den Längen der Permanentmagnete 43a, 43b und 43c ist zeichnerisch stark überhöht dargestellt. Durch nach innen hin schwächer werdende Magnetfelder wird eine bessere Homogenität der auf dem Substrat erhaltenen Schichtdicke erreicht. Mit einem solchen Sputterkopf können Sputtertargets von 60 mm Durchmesser und mehr verwendet werden und dabei homogene Schichtdicken mit homogener Target-Ausnutzung realisiert werden. Für noch größere Sputtertargets können noch mehr ringförmige Anordnungen von Permanentmagneten konzentrisch zueinander angeordnet werden.

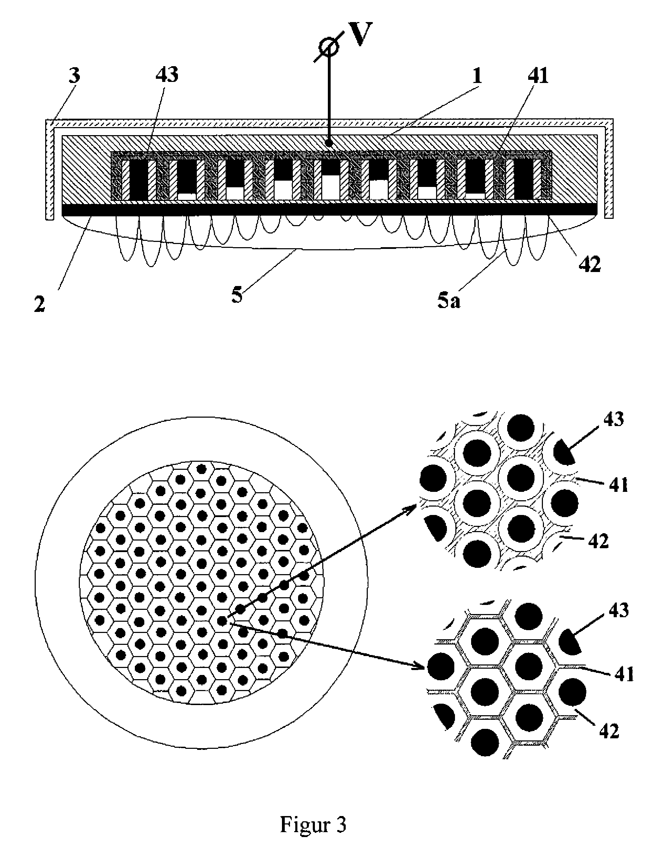

Figur 3 zeigt ein weiteres Ausführungsbeispiel des erfindungsgemäßen Sputterkopfes als Schnitte mit einer zur Substratoberfläche senkrechten (a) und mit einer zur Substratoberfläche parallelen (b) Ebene. Die Anordnung 4 von Magnetfeldquellen umfasst ein wabenförmig strukturiertes Eisen-Joch 41, in dessen Zellen Trägerelemente 42 auf Kupfer sowie zylindrische Permanentmagnete 43 eingesetzt sind. Sind die Permanentmagnete 43 mit ihrem magnetischen Nordpol zur Target-Aufnahme hin ausgerichtet, bildet das Eisen-Joch 41 den Südpol. Dieses Joch 41 besteht nicht aus mehreren Jochringen, sondern ist aus einem Stück gefertigt. Die einzelnen Zellen der Wabenstruktur können einen kreisrunden oder auch einen polygonalen (hier sechseckigen) Querschnitt haben.

Wie in Figur 3a durch die Längen der Permanentmagnete 43 und ihrer Beiträge 5a zur Verteilung des Sputterplasmas angedeutet ist, kommen Permanentmagnete unterschiedlicher Stärke zum Einsatz. Dabei sind die Unterschiede in den Stärken zeichnerisch stark überhöht clargestellt. Die schwächsten Magnete befinden sich in der Mitte; zum Rand hin werden die Magnete stärker. Damit wird der bei großen Targets normalerweise auftretende Schwächung und Destabilisierung des Sputterplasmas zum Rand hin entgegen gewirkt. Mit einem solchen Sputterkopf können, wie auch mit dem in Figur 2 gezeigten Ausführungsbeispiel, Sputtertargets von 60 mm Durchmesser und mehr verwendet werden und dabei homogene Schichtdicken mit homogener Target-Ausnutzung realisiert werden.

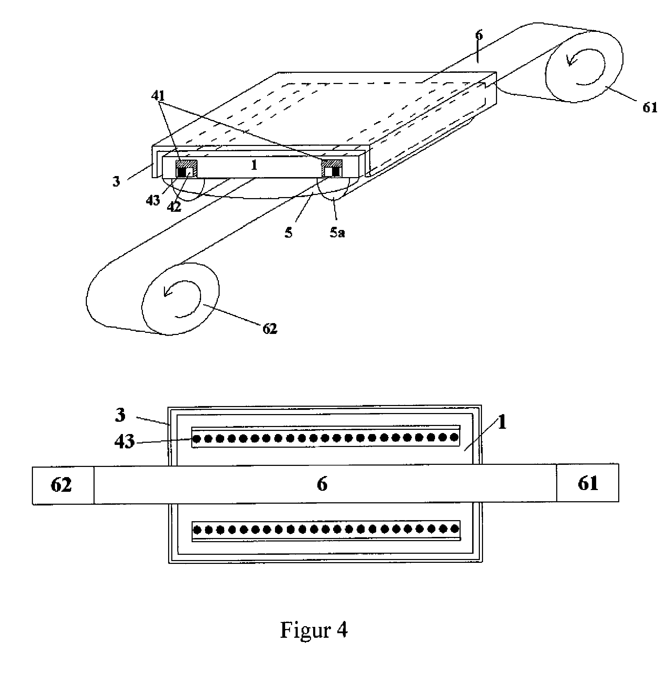

Figur 4 zeigt ein weiteres Ausführungsbeispiel des erfindungsgemäßen Sputterkopfes in perspektivischer Darstellung (a) sowie als Schnittzeichnung mit einer zur Substratoberfläche parallelen Ebene (b) Das Substrat 6 ist ein Band, das von einer Rolle 61 abgewickelt und nach dem Beschichten auf eine Rolle 62 aufgewickelt wird. Der Grundkörper 1 des Sputterkopfes ist quaderförmig. In ihn sind L-förmige Jochbalken 41 aus Eisen und quaderförmige Trägerelemente 42 aus Kupfer mit Bohrungen eingelassen. In die Bohrungen in den Trägerelementen 42 sind Permanentmagnete 43 eingesetzt. Jochbalken 4], Trägerelemente 42 und Permanentmagnete 43 bilden zusammen die Anordnung 4 von Magnetfeldquellen. Das Sputtertarget 2 sowie die Substratheizung sind aus Gründen der Übersichtlichkeit nicht eingezeichnet.

Analog zu Figur 1 befindet sich der magnetische Nordpol eines jeden Permanentmagneten 43 in unmittelbarer Nähe der Target-Aufnahme-Fläche 11 für das Sputtertarget, während der Südpol durch den L-förmigen Jochbalken 41 in die Nähe der Target-Aufnahme-Fläche geführt ist. Das entstehende Streufeld reicht in das Sputterplasma und bereichert dessen Verteilung 5 um Zusatzbeiträge 5a. Dadurch wird der Ionisationsgrad des Plasmas über die Breite des Sputterkopfes homogenisiert, so dass über die ganze Breite des Substrats 6 eine homogene Schicht aufgebracht werden kann. Die Bearbeitungszone kann beispielsweise eine Länge zwischen etwa 100 und etwa 1000 mm haben. Es ist vorgesehen, dass das Substratband 6 kontinuierlich am Sputterkopf vorbeiläuft und beschichtet wird.

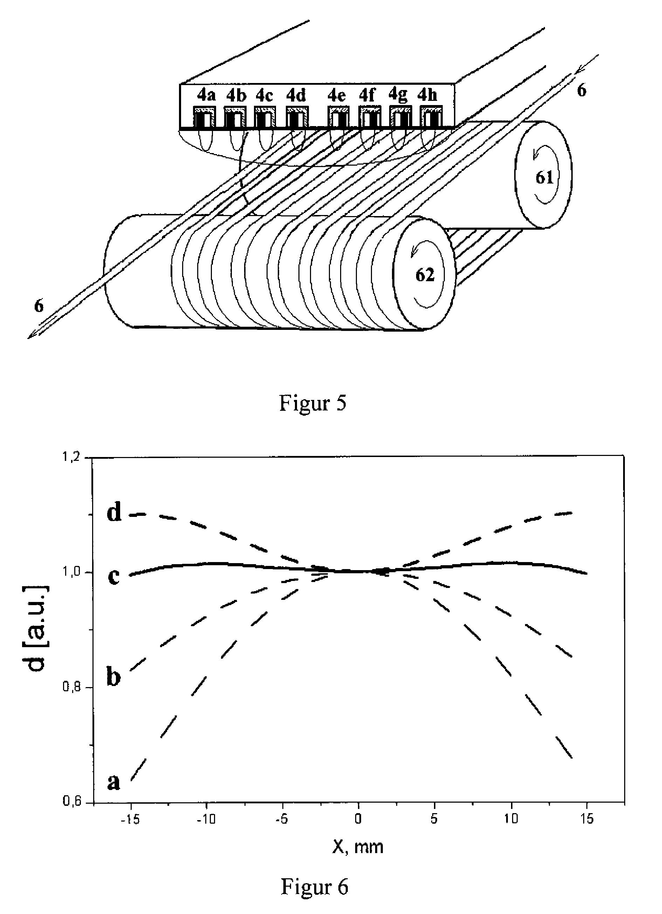

Figur 5 zeigt eine Abwandlung des in Figur 4 gezeigten Ausführungsbeispiels. Wie auch in Figur 4 ist die Substratheizung nicht eingezeichnet. Das Substratband 6 wird hier nicht von der Rolle 61 abgewickelt und auf die Rolle 62 aufgewickelt. Stattdessen wird es von diesen beiden Rollen, die sich gleichsinnig drehen, mehrfach umgelenkt, so dass es unter mehreren linienförmigen Anordnungen 4a-4h von Magnetfeldquellen entlangläuft und jeweils weiter beschichtet wird. Mit diesem Ausführungsbeispiel des Sputterkopfes kann eine größere Bandlänge pro Zeiteinheit mit einer vorgegebenen Schichtdicke belegt werden als dies mit dem in Figur 4 gezeigten Ausführungsbeispiel möglich ist.

In Figur 6 ist gezeigt, in welchem Maße die lokale Optimierung der Sputterrate durch lokale Magnetfelder nach Figur 1 die Homogenität der beim Sputtern erhaltenen Schichten verbessern kann. Ausgetragen ist für ein kreisrundes Substrat mit 30 mm Durchmesser jeweils die Schichtdicke d als Funktion des Abstands X von der Substratmitte. Dabei ist die Schichtdicke in willkürlichen Einheiten auf ihren Wert in der Substratmitte normiert. Kurve a zeigt die Verteilung der Schichtdicke für einen Spulterkopf ohne die erfindungsgemäß vorgesehenen Magnetfeldquellen. Kurve b zeigt die Verteilung, die ein Sputterkopf mit einer noch nicht optimalen erfindungsgemäßen Anordnung von Magnetfeldquellen erzeugt. Es ist bereits eine deutliche Verbesserung zu erkennen; so ist etwa der Bereich, in dem die Schichtdicke nicht unter 90 % ihres Wertes in der Substratmitte fällt, etwa um ein Drittel breiter. Kurve c zeigt die Verteilung, die sich für die optimale Verteilung von Magnetfeldquellen ergibt. Praktisch über den gesamten Substratdurchmesser von 30 mm weicht die Schichtdicke nur noch um weniger als etwa 3 % von ihrem Wert in der Substratmitte ab. Derart geringe Abweichungen sind für Funktionsschichten in der Regel tolerierbar. Kurve d zeigt die Schichtdicken-Verteilung für den Fall zu starker Magnetfeldquellen nach Figur 1. Hier wird der Abfall der Schichtdicke zum Rand hin, der der Anlass für den Einsatz der lokalen Magnetfeldquellen war, überkompensiert.

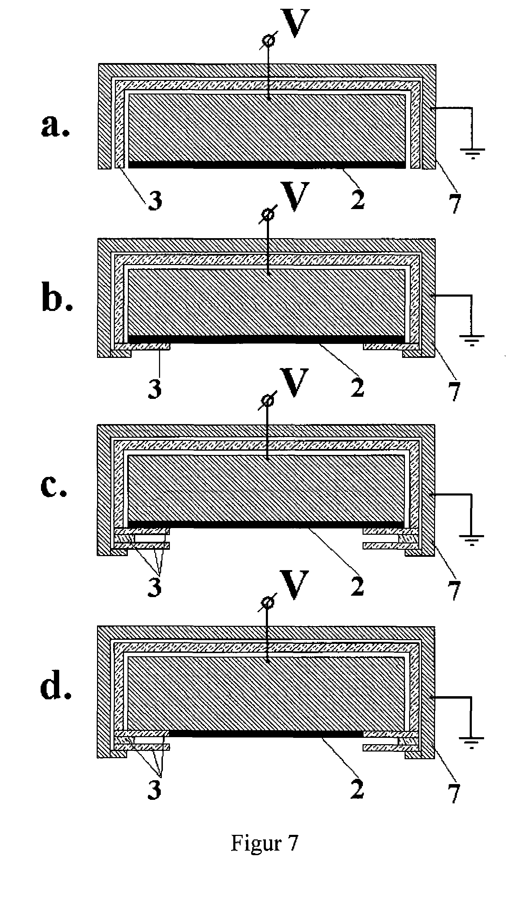

Figur 7 zeigt Ausführungsbeispiele für erfindungsgemäße Sputterköpfe mit Festkörperisolaloren in Schnittzeichnung. In Figur 7a ist lediglich ein Festkörperisolator 3 zwischen dem Grundkörper 1 und der Abschirmung 7 vorgesehen.

In Figur 7b ist ein weiterer ringförmiger Festkörperisolator 32 vorgesehen, der den Randbereich des Sputtertargets 2 bedeckt. Dieser Isolator 33 verhindert, dass sich das Sputterplasmas auf den Rand erstreckt und dort direkte elektrische Überschläge zwischen dem Grundkörper 1 oder dem Target 2 einerseits und der Abschirmung 7 andererseits auftreten.

Dieser Schutz kann jedoch verlorengehen, wenn vom Target 2 abgetragenes leitendes Material zum Teil auf dem Isolator 33 deponiert wird. Darum sieht das in Figur 7c gezeigte Ausführungsbeispiel einen weiteren Isolatorring 34 vor, der über ein oder mehrere Abstandsstücke 35 vom ersten Isolatorring 33 beabstandet ist. Vom Target abgetragenes Material kann dann nur auf dem Isolatorring 34, nicht jedoch auf dem Isolatorring 33 deponiert werden.

In Figur 7d ist der Isolatorring 33 nicht vor der Oberfläche des Targets 2, sondern vor der Oberfläche der Target-Aufnahme 11 angeordnet. Ein unerwünschter Materialabtrag im zur Abschirmung nächstgelegenen Randbereich, der zu elektrischen Überschltigen führen kann, wird auf die gleiche Weise verhindert wie in dem in Figur 7c gezeigten Ausführungsbeispiel. Im Unterschied zu Figur 7c kann jedoch ein kleineres und damit preiswerteres Target verwendet werden, dessen Oberfläche vollstandig genutzt wird. In den Figuren 7b und 7c liegt jeweils der vom Isolatorring 33 bedeckte Teil des Targets 2 brach.

## Patentansprüche

1. Sputterkopf mit einer Aufnahme (11) für ein Sputtertarget (2) und einer oder mehreren Magnetfeldquellen zur Erzeugung eines magnetischen Streufelds mit Feldlinien, die aus der Oberfläche des Sputtertargets (2) austreten und wieder in diese eintreten, wobei der Nordpol und der Südpol mindestens einer Magnetfeldquelle, zwischen denen sich das Streufeld ausbildet, 10 mm oder weniger, bevorzugt 5 mm oder weniger und ganz besonders bevorzugt etwa 1 mm, voneinander entfernt sind,
**dadurch gekennzeichnet, dass**
die Target-Aufnahme (11) von einer Abschirmung zur räumlichen Beschränkung des Materialabtrags auf das Sputtertarget (2) umgeben ist und dass zwischen der Target-Aufnahme (11) und der Abschirmung ein Festkörperisolator (3) angeordnet ist.

2. Sputterkopf nach Anspruch 1,
**dadurch gekennzeichnet, dass**
in der Projektion des Streufelds jeder Magnetfeldquelle auf die Oberfläche der Target-Aufnahme (11) der Bereich, in dem mindestens 90 % der Feldstärke konzentriert sind, vollständig außerhalb eines vorgegebenen Bereichs liegt, der vom Materialabtrag verschont bleiben soll.

3. Sputterkopf nach einem der Ansprüche 1 bis 2,
**dadurch gekennzeichnet, dass**
die Magnetfeldquelle mindestens einen Permanentmagneten (43) umfasst, dessen Feld durch ein Joch (41) aus magnetisch permeablem Material geführt ist.

4. Sputterkopf nach Anspruch 3,
**dadurch gekennzeichnet, dass**
die Flüsse mehrerer Permanentmagnete (43) durch ein und dasselbe Joch (41) geführt sind.

5. Sputterkopf nach einem der Ansprüche 1 bis 4,
**gekennzeichnet durch** eine oder mehrere ring- oder linienförmige Anordnungen von Magnetfeldquellen.

6. Sputterkopf nach einem der Ansprüche 1 bis 5
**dadurch gekennzeichnet, dass**
ein vor der dem Sputterplasma zugewandten Oberfläche des Sputtertargets (2) oder der Target-Aufnahme (11) fixierbarer Festkörperisolator (3) vorgesehen ist, welcher im Betrieb die am nächsten zur Abschirmung gelegenen 20 % oder weniger, bevorzugt die am nächsten zur Abschirmung gelegenen 10 % oder weniger und ganz besonders bevorzugt die am nächsten zur Abschirmung gelegenen 5 % oder weniger dieser Oberfläche vom Materialabtrag auszunehmen vermag.

7. Verfahren zur Sputterdeposition eines Targetmaterials mit einem Sputterkopf, gemäß einem der Ansprüche 1 bis 6, auf einem Substrat (6) bei einem Druck von 0,5 mbar oder mehr, bevorzugt von 1 mbar oder mehr, wobei zwischen der Targetoberfläche und dem Substrat (6) ein Plasma des Sputtergases gebildet wird,
**dadurch gekennzeichnet, dass**
von der Targetoberfläche in Richtung des Plasmas emittierte Elektronen im Plasma durch die Feldlinien einer oder mehrerer Magnetfeldquellen abgelenkt werden, deren Nordpol und Südpol 10 mm oder weniger, bevorzugt 5 mm oder weniger und ganz besonders bevorzugt etwa 1 mm, voneinander entfernt sind.

## Claims

1. Sputtering head having a mounting (11) for a sputtering target (2) and having one or more magnetic-field sources for generating a stray magnetic field having field lines which emerge from the surface of the sputtering target (2) and re-enter the same, the north pole and south pole of at least one magnetic-field source, between which the stray field forms, being at a distance from one another of 10 mm or less, and preferably of 5 mm or less and, as a very special preference, of approximately 1 mm, **characterised in that** the target mounting (11) is surrounded by a shield to spatially restrict the erosion of material to the sputtering target (2) and **in that** an insulator (3) in the form of a solid is arranged between the target mounting (11) and the shield.

2. Sputtering head according to claim 1, **characterised in that**, if the stray field of each magnetic field source is projected onto the surface of the target mounting (11), that region of the projected stray field in which at least 90% of the field strength is concentrated is situated entirely outside a preset region which is to be preserved from the erosion of material.

3. Sputtering head according to either of claims 1 and 2, **characterised in that** the magnetic-field source comprises at least one permanent magnet (43) whose field is guided by a yoke (41) of magnetically permeable material.

4. Sputtering head according to claim 3, **characterised in that** the fluxes of a plurality of permanent magnets (43) are guided by one and the same yoke (41).

5. Sputtering head according to one of claims 1 to 4, **characterised by** one or more annular or linear arrangements of magnetic-field sources.

6. Sputtering head according to one of claims 1 to 5, **characterised in that** there is provided an insulator (3), in the form of a solid, which can be fixed in place in front of that surface of the sputtering target (2) or of the target mounting (11) which is adjacent to the sputtering plasma, which insulator (3) is able, in operation, to prevent the 20% or less of the said surface which is situated closest to the shield, and preferably the 10% or less thereof which is situated closest to the shield, and as a very special preference the 5% or less thereof which is situated closest to the shield, from being subject to the erosion of material.

7. Method for the deposition by sputtering of a target material by a sputtering head according to one of claims 1 to 6, on a substrate (6), at a pressure of 0.5 mbars or more, and preferably of 1 mbar or more, a plasma of the sputtering gas being formed between the surface of the target and the substrate (6), **characterised in that** electrons emitted from the surface of the target towards the plasma are diverted in the plasma by the field lines of one or more magnetic-field sources whose north pole and south pole are at a distance from one another of 10 mm or less, and preferably of 5 mm or less and, as a very special preference, of approximately 1 mm.

## Revendications

1. Tête de pulvérisation cathodique comprenant un logement (11) pour une cible de pulvérisation cathodique (2) et une ou plusieurs sources de champ magnétique servant à produire un champ de dispersion magnétique pourvu de lignes de champ, qui sortent de la surface de la cible de pulvérisation cathodique (2) et qui y entrent à nouveau, sachant que le pôle nord et le pôle sud au moins d'une source de champ magnétique, entre lesquels le champ de diffusion se forme, sont espacés l'un de l'autre d'une distance inférieure ou égale à 10 mm, de manière préférée d'une distance inférieure ou égale à 5 mm et de manière idéale d'une distance d'environ 1 mm,
**caractérisée en ce que**
le logement de cible (11) est entouré d'un blindage servant à limiter de manière spatiale l'enlèvement de matériau sur la cible de pulvérisation cathodique (2), et **en ce qu'**un isolateur de corps solides (3) est disposé entre le logement de cible (11) et le blindage.

2. Tête de pulvérisation cathodique selon la revendication 1,
**caractérisée en ce que**
dans la projection du champ de diffusion de chaque source de champ magnétique sur la surface du logement de cible (11), la zone, dans laquelle au moins 90 % de l'intensité de champ est concentrée, se situe totalement à l'extérieur d'une zone prédéfinie, qui est censée rester épargnée par l'enlèvement de matériau.

3. Tête de pulvérisation cathodique selon l'une quelconque des revendications 1 à 2,
**caractérisée en ce que**
la source de champ magnétique comprend au moins un aimant permanent (43), dont le champ est guidé par une culasse (41) composée d'un matériau magnétiquement perméable.

4. Tête de pulvérisation cathodique selon la revendication 3,
**caractérisée en ce que**
les flux de plusieurs aimants permanents (43) sont guidés par une seule et même culasse (41).

5. Tête de pulvérisation cathodique selon l'une quelconque des revendications 1 à 4,
**caractérisée par** un ou plusieurs ensembles de forme annulaire ou de forme linéaire de sources de champ magnétique.

6. Tête de pulvérisation cathodique selon l'une quelconque des revendications 1 à 5,
**caractérisée en ce**
**qu'**est prévu un isolateur de corps solides (3) pouvant être fixé devant la surface, tournée vers le plasma de pulvérisation cathodique, de la cible de pulvérisation cathodique (2) ou du logement de cible (11), lequel est en mesure, en fonctionnement, de retirer de l'enlèvement de matériau 20 % ou moins de ladite surface situés immédiatement après le blindage, de manière préférée 10 % ou moins de ladite surface situés immédiatement après le blindage, et idéalement 5 % ou moins de ladite surface situés immédiatement après le blindage.

7. Procédé servant à déposer par pulvérisation cathodique un matériau cible à l'aide d'une tête de pulvérisation cathodique selon l'une quelconque des revendications 1 à 6 sur un substrat (6) à une pression supérieure ou égale à 0,5 mbar, de préférence supérieure ou égale à 1 mbar, sachant qu'un plasma du gaz de pulvérisation cathodique est formé entre sur la surface de cible et le substrat (6),
**caractérisé en ce que**
des électrons émis par la surface de cible en direction du plasma sont déviés dans le plasma par les lignes de champ d'une ou de plusieurs sources de champ magnétique, dont le pôle nord et le pôle sud sont éloignés l'un de l'autre d'une distance inférieure ou égale à 10 mm, de manière préférée d'une distance inférieure ou égale à 5 mm et de manière idéale d'une distance d'environ 1 mm.
